# EUROPEAN PATENT APPLICATION

(11) **EP 2 293 660 A2**
(43) Date of publication of application: **09.03.2011**
(21) Application number: 10174704.6
(22) Date of filing: 31.08.2010
(51) Int. Cl.: H05K 7/20

(54) **Temperature predicting apparatus and method**

(30) Priority: 04.09.2009 JP 2009205325
(71) Applicant: FUJITSU LIMITED, Kawasaki-shi, Kanagawa 211-8588 (JP)
(72) Inventor: Yamaoka, Nobuyoshi, Kawasaki-shi Kanagawa 211-8588 (JP); Ishimine, Junichi, Kawasaki-shi Kanagawa 211-8588 (JP); Nagamatsu, Ikuro, Kawasaki-shi Kanagawa 211-8588 (JP); Suzuki, Masahiro, Kawasaki-shi Kanagawa 211-8588 (JP); Katsui, Tadashi, Kawasaki-shi Kanagawa 211-8588 (JP); Ohba, Yuji, Kawasaki-shi Kanagawa 211-8588 (JP); Saito, Seiichi, Kawasaki-shi Kanagawa 211-8588 (JP); Ueda, Akira, Kawasaki-shi Kanagawa 211-8588 (JP); Uraki, Yasushi, Kawasaki-shi Kanagawa 211-8588 (JP)
(74) Representative: Ward, James Norman

(57) **Abstract**

A temperature predicting apparatus for predicting possible abnormal temperature of air for cooling at least one of electronic devices mounted on a rack, the temperature predicting apparatus includes a storing section for storing temperature information related to at least one temperature measured by a temperature sensor provided on an intake side of the electronic device, and a controller for estimating a change tendency in the temperature on the intake side of the electronic device on the basis of the temperature information stored in the storing section, and predicting the possible abnormal temperature on the basis of the estimated change tendency.

## Description

### FIELD

The embodiments discussed herein are related to a temperature predicting apparatus, a temperature predicting method, and a storage medium for storing a temperature predicting program.

### BACKGROUND

In data centers and computer rooms including racks mounting electronic devices, (e.g., information technology (IT) devices, such as computers, servers, and routers), the IT devices are cooled with air conditioners that take in warm air and supply cooling air.

A temperature rise in data centers caused by the increasing density and power consumption of IT device mounted in racks prevents the IT devices from being sufficiently cooled. The remaining heat may cause a system failure. For example, since IT devices or racks are not regularly arranged or do not have a uniform installation environment in general data centers, amounts of heat generated by the racks and central processing units (CPUs) included in the IT devices vary. Accordingly, some IT devices, unfortunately, are not sufficiently cooled to have temperature exceeding an allowable level. The temperature rise in the data centers may also cause the air conditioners supplying cooling air to malfunction or abnormally stop operation. If the temperature in the data centers drops too much, the operation mode of the air conditioners switches into the heating mode.

Technologies using temperature sensors and airflow sensors and using air conditioners automatically switching between cooling and heating operations are known as methods for solving such problems. For example, a rack-type electronic apparatus according to the related art includes a temperature sensor and an airflow sensor installed for each IT device mounted in a rack. Upon detecting temperature or airflow exceeding a threshold, the sensor informs the rack-type electronic apparatus of occurrence of an abnormal state using an alarm. The rack-type electronic apparatus according the related art then performs feed back-control on the rotation rate of a fan to adjust the temperature or the airflow. Additionally, an air conditioner is known that performs a cooling operation when room temperature exceeds an upper limit and a heating operation when the room temperature falls bellow a lower limit.

However, the technologies according to the related art unfortunately do not prevent or early detect a possible abnormal state because an alarm is generated after occurrence of the abnormal state.

Additionally, the technologies in the related art may unfortunately induce an abnormal state in IT devices and increase a cost for cooling the TT devices. For example, in a technology according to the related art, whether room temperature has reached an upper or lower limit is determined. Accordingly, for example, a cooling operation may effective for some IT devices but the other IT devices may be cooled too much. As a result, the cooling operation induces an abnormal state in those IT devices. Additionally, since an operation for switching between the cooling operation and the heating operation consumes more power than regular operations, such as the cooling operation, an electric costs increases in proportion to the frequency of the switching operation if the switching operation is frequently executed. Thus, a technology is desired that efficiently cools IT devices while suppressing the cost.

The followings are reference documents.

[Patent Document 1] Japanese Laid-open Patent Publication No. 2008-34715

[Patent Document 2] Japanese Laid-open Patent Publication No. 2007-170686

### SUMMARY

Accordingly, it is an object in one aspect of the embodiment to provide a temperature predicting apparatus, a temperature predicting method, and a temperature predicting program so as to prevent or early detect possible abnormal temperature of air for use in cooling of IT devices.

According to an aspect of the embodiment, a temperature predicting apparatus for predicting possible abnormal temperature of air for cooling at least one of electronic devices mounted on a rack, the temperature predicting apparatus includes a storing section for storing temperature information related to at least one temperature measured by a temperature sensor provided on an intake side of the electronic device, and a controller for estimating a change tendency in the temperature on the intake side of the electronic device on the basis of the temperature information stored in the storing section, and predicting the possible abnormal temperature on the basis of the estimated change tendency.

### BRIEF DESCRIPTION OF DRAWINGS

FIG. 1 is a diagram illustrating a configuration of a temperature predicting system using a temperature predicting apparatus according to a first embodiment;

FIG. 2 is a block diagram illustrating a configuration of the temperature predicting apparatus according to the first embodiment;

FIG. 3 is a diagram illustrating an example of information stored in a temperature history database (DB);

FIG. 4 is a diagram describing an example of estimating abnormal temperature;

FIG. 5 is a flowchart illustrating a flow of processing executed by the temperature predicting apparatus according to the first embodiment;

FIG. 6 is a diagram illustrating a configuration of a temperature predicting system including a temperature sensor installed for each IT device;

FIG. 7 is a diagram illustrating an example of temperature information acquired from the temperature sensor installed for each IT device;

FIG. 8 is a flowchart describing a flow of processing executed by a temperature predicting apparatus according to a third embodiment;

FIG. 9 is a diagram describing a method for calculating time for temperature to reach a predetermined threshold on the basis of an estimated temperature change tendency; and

FIG. 10 is a diagram illustrating a computer system executing a temperature predicting program.

### DESCRIPTION OF EMBODIMENTS

Preferred embodiments of the present techniques will be explained with reference to accompanying drawings.

A temperature predicting apparatus, a temperature predicting method, and a temperature predicting program according to embodiments of this technology will be described in detail below with reference to the accompanying drawings. The embodiments do not limit this technology.

### [First Embodiment]

In a first embodiment, a configuration of a temperature predicting system using a temperature predicting apparatus according to the first embodiment, a configuration of the temperature predicting apparatus, a processing flow, and advantages of the first embodiment will be described.

### [Configuration of the temperature predicting system]

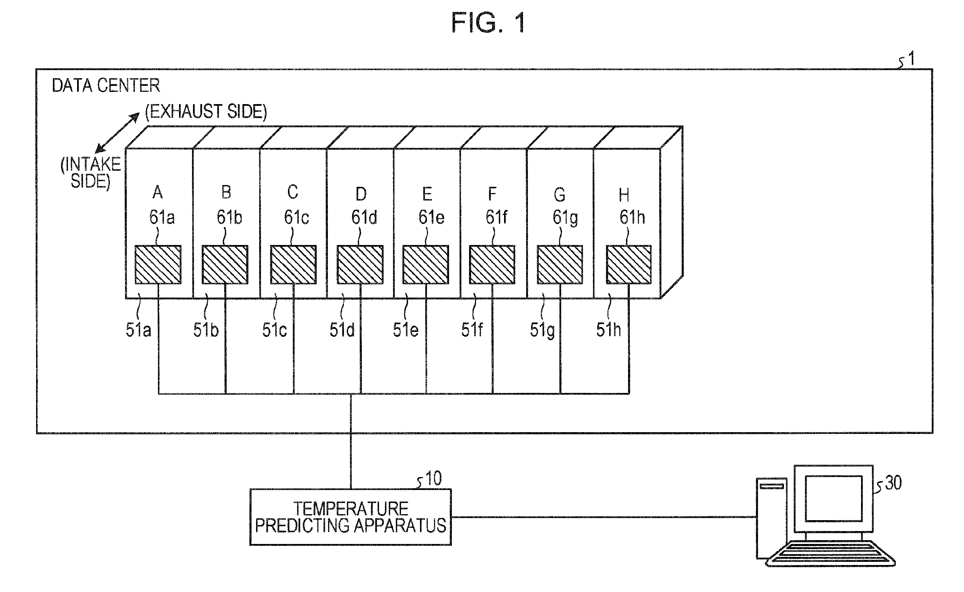

A configuration of the temperature predicting system using the temperature predicting apparatus according to the first embodiment will now be described using FIG. 1. FIG. 1 is a diagram illustrating the configuration of the temperature predicting system using the temperature predicting apparatus according to the first embodiment.

As illustrated in FIG. 1, the temperature predicting system includes a data center 1, a temperature predicting apparatus 10, and a data processing apparatus 30. The data center 1 includes racks (Nos. A-H) 51a-51h for storing information technology (IT) devices, air conditioners (not illustrated) for taking in exhaust air of the IT devices and supplying cooling air under a floor, and perforated tiles (not illustrated) for circulating the underfloor cooling air to an area above the floor. The IT devices take in the cooling air supplied by the air conditioners, cool internal electronic devices thereof with the air, and then emit the air used in cooling to the room.

The racks (Nos. A-H) 51a-51h installed in the data center 1 have temperature sensors 61a-61h on an intake side of the IT devices stored therein, i.e., on the side having inlets through which the IT devices take in air with fans, respectively. Each of the temperature sensors 61a-61h detects temperature of the air taken in by the IT devices and outputs the detected temperature to the temperature predicting apparatus 10.

The temperature predicting apparatus 10 acquires temperature from each of the temperature sensors 61a-61h installed on the intake side of the IT devices stored in the racks 51a-51h, respectively, estimates a temperature transition on the basis of the acquired temperature, and predicts possible abnormal temperature on the basis of the estimated temperature transition. The temperature predicting apparatus 10 feeds (outputs) a predicted result to the data processing apparatus 30. For example, the predicted result may indicate that temperature of the rack (No. D) 51d is highly likely to reach a dangerous level or that the rack (No. E) 51e is possibly suffering from recirculation of exhaust air.

The recirculation of exhaust air is a phenomenon in which exhaust air of IT devices, namely, warm air having been used in cooling, is not taken in by air conditioners but by the IT devices.

The recirculation of exhaust air impedes removal of heat to produce an area with a rising temperature, i.e., a hot spot, or accumulated heat. When the exhaust air recirculates, the IT devices fail to sufficiently cool internal electronic devices because the IT devices take in warm exhaust air thereof instead of cooling air. As a result, the internal electronic devices have high temperature that causes a system down or a system failure.

The data processing apparatus 30 is a computer for executing various kinds of processing on the basis of the predicted result fed from the temperature predicting apparatus 10. For example, the data processing apparatus 30 informs a manager of a possible temperature abnormality using an alarm or sends a warning mail indicating the possible temperature abnormality. When the data processing apparatus 30 is connected to each of the IT devices stored in the racks, the data processing apparatus 30 may control the IT device predicted to possibly suffer from abnormal temperature so that the rotation rate of a fan thereof increases.

### [Configuration of the temperature predicting apparatus 10]

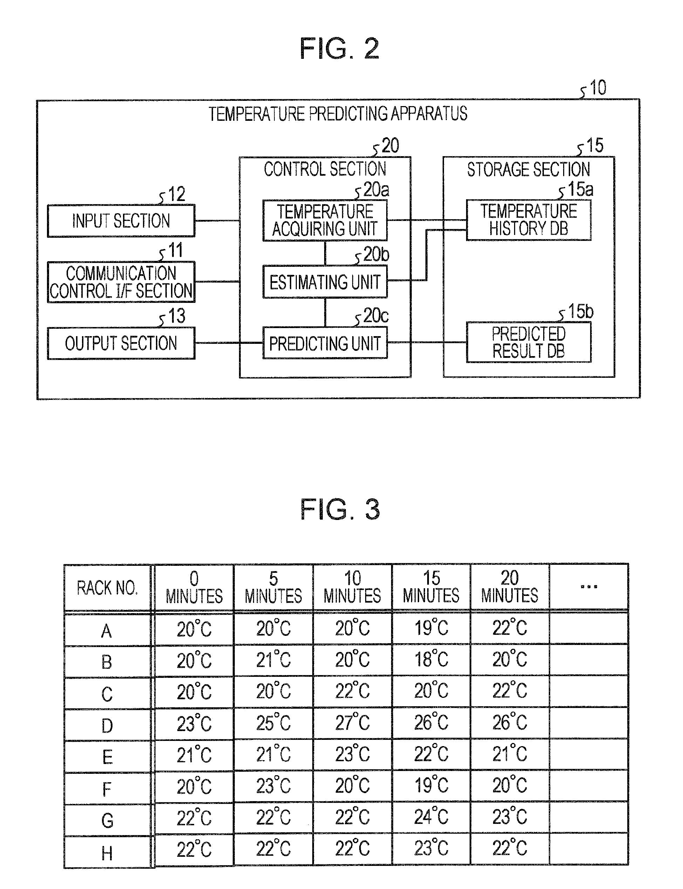

A configuration of the temperature predicting apparatus 10 illustrated in FIG. 1 will now be described using FIG. 2. FIG. 2 is a block diagram illustrating the configuration of the temperature predicting apparatus 10 according to the first embodiment.

As illustrated in FIG. 2, the temperature predicting apparatus 10 includes a communication control interface (I/F) section 11, an input section 12, an output section 13, a storage section 15, and a control section 20. The communication control I/F section 11 is an interface having a plurality of ports and controls information exchanged with other apparatuses.

For example, the communication control I/F section 11 sends a result of abnormal-temperature prediction to the data processing apparatus 30 connected thereto.

The input section 12 is input parts for accepting input of various kinds of information. The input section 12 includes, for example, a keyboard, a mouse, and a microphone. For example, the input section 12 accepts instructions for starting and terminating temperature prediction and then supplies the instructions to the control section 20 described later. The output section 13 described later realizes a function of a pointing device in cooperation with the mouse.

The output section 13 is displaying and outputting parts for outputting various kinds of information. The output section 13 includes, for example, a monitor, a display, a touch panel, and a speaker. The output section 13 displays a predicted result acquired by the control section 20.

The storage section 15 is semiconductor memory elements, such as a random access memory (RAM), a read only memory (ROM), and a flash memory; or storage devices, such as a hard disk drive (HDD) and an optical disc. The storage section 15 stores data and programs for used in various kinds of processing executed by the control section 20. Additionally, the storage section 15 includes a temperature history database (DB) 15a and a predicted result DB 15b. The storage section 15 is an example of the storing section.

The temperature history DB 15a is a storage device for storing temperature information acquired by a temperature acquiring unit 20a described later. For example, as illustrated in FIG. 3, the temperature history DB 15a chronologically stores temperature acquired for each "rack No." for identifying a rack. FIG. 3 illustrates an example of stored temperature acquired from the temperature sensors 61a-61h for the racks (Nos. A-H) 51a-51h every five minutes, respectively. FIG. 3 is a diagram illustrating an example of information stored in the temperature history DB 15a.

The example of FIG. 3 indicates that temperature acquired from the temperature sensor 61a for the rack (No. A) 51a is 20°C at a point of measurement start (after 0 minutes), 20°C after 5 minutes, 20°C after 10 minutes, 19°C after 15 minutes, and 22°C after 20 minutes.

The temperature history DB 15a may also store the temperature information in various forms other than the one illustrated in FIG. 3. For example, the temperature history DB 15a may store the temperature information in association with location information of the racks 51a-51h or the temperature sensors 61a-61h (in three-dimensional coordinates represented with x, y, and z axes) obtained when the data center 1 is divided into three-dimensional mesh with the finite volume method. In this way, the locations (areas) of the racks in the data center 1 may be identified. Although the location information is three-dimensionally represented in this example, two-dimensional coordinates represented with "x and y axes" may be used.

The predicted result DB 15b is a storage device for storing results predicted by a predicting unit 20c described later. For example, the predicted result DB 15b stores results predicted by the predicting unit 20c: temperature of the rack (No. D) 51d is highly likely to reach a dangerous level; and the rack (No. E) 51e is possibly suffering from recirculation of exhaust air. These predicted results are illustrative only and contents of the predicted results are not limited to the examples.

The control section 20 is, for example, an integrated circuit, such as an application specific integrated circuit (ASIC) or a field programmable gate array (FPGA); or an electronic circuit, such as a central processing unit (CPU) or a micro processing unit (MPU).

The control section 20 includes an internal memory for storing a control program, such as an operating system (OS), programs defining various processing procedures, and data. The control section 20 also includes the temperature acquiring unit 20a, an estimating unit 20b, and the predicting unit 20c. The controlling section 20 executes various kinds of processing with the temperature acquiring unit 20a, the estimating unit 20b, and the predicting unit 20c. The control section 20 is an example of the controller.

The temperature acquiring unit 20a is connected to the temperature history DB 15a and the estimating unit 20b. The temperature acquiring unit 20a acquires temperature from the temperature sensors 61a-61h installed on the intake side of the IT devices stored in the racks 51a-51h, respectively. In the foregoing example, the temperature acquiring unit 20a acquires, at predetermined intervals, temperature detected by the temperature sensors 61a-61h installed in the racks (Nos. A-H) 51a-51h, respectively, namely, temperature of air taken in by the IT devices. For example, once the input section 12 accepts an instruction for starting temperature measurement, the temperature acquiring unit 20a starts acquiring the temperature. The temperature acquiring unit 20a acquires, every five minutes, the temperature from the temperature sensors 61a-61h installed in the racks (Nos. A-H) 51a-51h, respectively. The temperature acquiring unit 20a associates the acquired temperature with the corresponding racks to create chronological temperature information and stores the created temperature information in the temperature history DB 15a. A manager may set or change the temperature acquisition intervals to any value.

The estimating unit 20b is connected to the temperature history DB 15a and the temperature acquiring unit 20a. The estimating unit 20b estimates a temperature change tendency (transition) on the basis of the temperature acquired by the temperature acquiring unit 20a. More specifically, after a predetermined time (e.g., after one hour) since the temperature acquiring unit 20a has started acquiring the temperature, the estimating unit 20b estimates a change tendency of the temperature of air taken in by the IT devices on the basis of the temperature information acquired up to that point. For example, the estimating unit 20b creates a graph whose horizontal and vertical axes representing time "t" and a temperature rise "T", respectively. The estimating unit 20b then performs interpolation, such as linear interpolation or polynomial interpolation, to create a graph of the temperature change of intake air in association with each rack. The manager may set or change the predetermined time to any value. An actually measured temperature value may be used instead of the temperature rise T.

When the three-dimensional coordinates are associated with each rack in the temperature history DB 15a, the estimating unit 20b may graphically visualize the temperature change tendency in the data center 1 in three dimension using the created graph of the temperature change. More specifically, the estimating unit 20b may chronologically display the temperature change tendency in the data center 1, that is, may perform numerical-analysis simulation of the temperature change tendency in the data center 1.

The predicting unit 20c is connected to the estimating unit 20b and the predicted result DB 15b. The predicting unit 20c predicts possible abnormal temperature on the basis of the temperature change tendency estimated by the estimating unit 20b. More specifically, the predicting unit 20c predicts, on the basis of the graph created by the estimating unit 20b, that temperature of the rack (No. D) 51d is highly likely to reach a dangerous level or that the rack (No. E) 51e is possibly suffering from recirculation of exhaust air. The predicting unit 20c then stores the predicted result in the predicted result DB 15b.

For example, when a slope (indicating a temperature change tendency) of the graph created by the estimating unit 20b is larger than a predetermined value, the predicting unit 20c predicts that temperature of the rack is highly likely to reach the dangerous level. When the graph created by the estimating unit 20b includes a sharp temperature rise at a predetermined time point or continuous high temperature, the predicting unit 20c predicts that the rack is possibly suffering from recirculation of exhaust air.

According to another prediction method, the predicting unit 20c calculates a temperature gradient "dT/dt" on the basis of the temperature change tendency estimated by the estimating unit 20b, for example. If the calculated temperature gradient exceeds a predetermined threshold, the predicting unit 20c generates an alarm to report possible abnormal temperature. More specifically, the predicting unit 20c creates a graph by interpolating, with a cubic curve, the graph of the temperature change tendency created by the estimating unit 20b to calculate the temperature gradient. Here, the character "T" represents measured temperature, whereas a character "t" represents time. The character "T" may represent a temperature rise from the start of measurement.

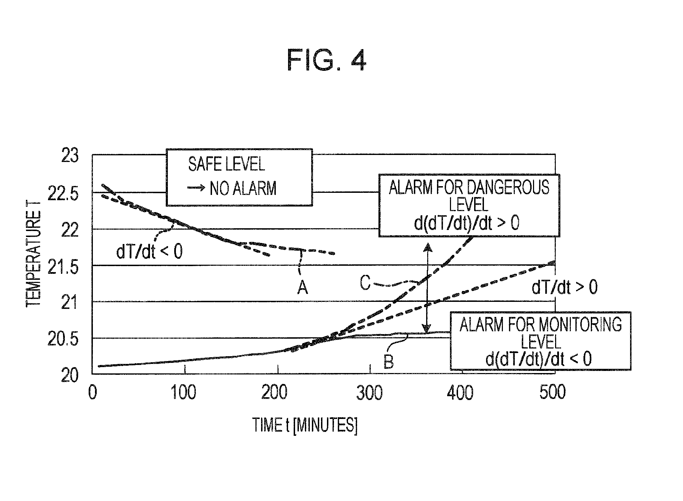

FIG. 4 is a diagram illustrating an example of predicting possible abnormal temperature. For example, the estimating unit 20b creates graphs A, B, and C illustrated in FIG. 4. Since the graph A has the temperature gradient "dT/dt" smaller than zero, the predicting unit 20c determines that a possibility that abnormal temperature occurs is low and predicts that the rack is safe. The graph B has the temperature gradient "dT/dt" larger than zero but has a second derivative "d(dT/dt)/dt" of the temperature gradient smaller than zero. Accordingly, the predicting unit 20c predicts that a possibility that the abnormal temperature immediately occurs is low but the abnormal temperature may occur in a long term and, thus, the rack has to be monitored. The graph C has the temperature gradient "dT/dt" and the second derivative "d(dT/dt)/dt" larger than zero. Accordingly, the predicting unit 20c predicts that the possibility that the abnormal temperature immediately occurs is high and the rack is in danger.

The predicting unit 20c then generates and outputs information indicating which rack is "to be monitored" or "in danger" to the data processing apparatus 30 as an alarm. When each rack has light emitting diodes (LEDs), the predicting unit 20c may control the rack "to be monitored" so that a "bellow" LED is turned on. Additionally, the predicting unit 20c may control the rack "in danger" so that a "red" LED is turned on.

When the data center 1 is three-dimensionally (graphically) visualized by the estimating unit 20b, the predicting unit 20c may display an area including the rack "to be monitored" in "yellow". Additionally, the predicting unit 20c may display an area including the rack "in danger" in "red". In this way, the predicting unit 20c may briefly display the temperature transition and information on the dangerous temperature of the data center 1 in detail.

When the predicting unit 20c is connected to the IT devices stored in the racks (Nos. A-H) 51a-51h, the predicting unit 20c may perform feedback-control on each IT device stored in the racks predicted to possibly suffer from abnormal temperature so that the rotation rate of a fan thereof increases.

### [Flow of processing executed by the temperature predicting apparatus 10]

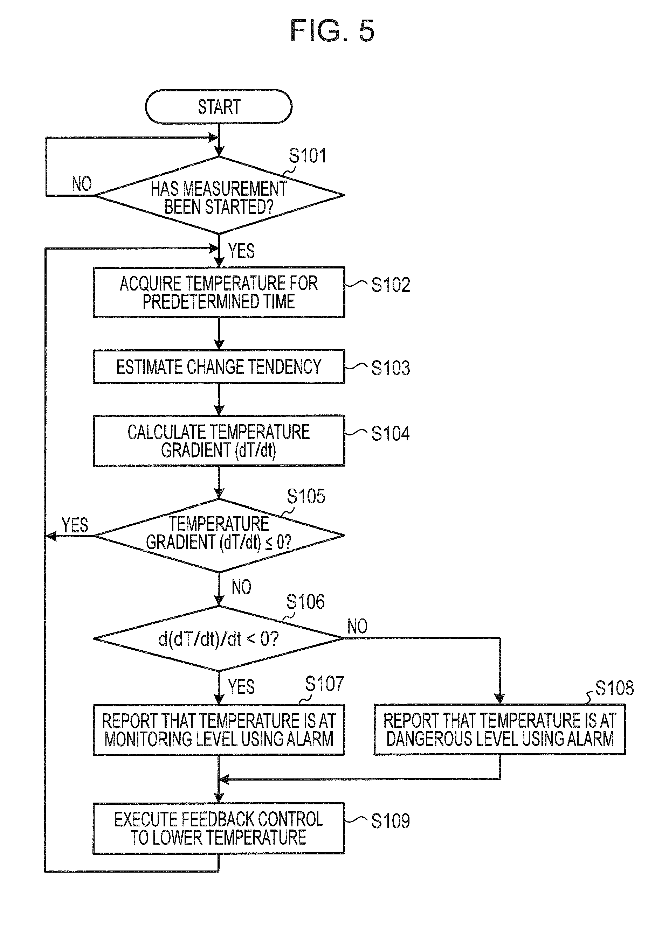

A flow of processing executed by the temperature predicting apparatus 10 according to the first embodiment will now be described using FIG. 5.

FIG. 5 is a flowchart illustrating the flow of the processing executed by the temperature predicting apparatus 10 according to the first embodiment. Herein, a description is given for an example of a flowchart for predicting possible abnormal temperature using a temperature gradient.

As illustrated in FIG. 5, the temperature acquiring unit 20a starts measuring temperature once the input section 12 accepts an instruction for starting temperature prediction (YES in S101). The temperature acquiring unit 20a acquires temperature from the temperature sensors 61a-61h for a predetermined time and stores the acquired temperature in the temperature history DB 15a (S102).

The estimating unit 20b estimates a temperature change tendency of intake air of IT devices stored in each rack using the temperature information acquired during the predetermined time (S103). After the estimation of the temperature change tendency, the predicting unit 20c calculates a temperature gradient "dT/dt" on the basis of the temperature change tendency estimated by the estimating unit 20b (S104). The predicting unit 20c then determines whether the calculated temperature gradient is smaller than or equal to zero (S105).

If the calculated temperature gradient "dT/dt" is smaller than or equal to zero (YES in S105), the predicting unit 20c predicts that a possibility that abnormal temperature occurs is low and the rack is safe. The temperature predicting apparatus 10 then repeats the processing from S102.

If the calculated temperature gradient "dT/dt" is larger than zero (NO in S105), the predicting unit 20c determines whether a second derivative "d(dT/dt)/dt" of the temperature gradient is smaller than zero (S106).

If the second derivative "d(dT/dt)/dt" of the temperature gradient is smaller than zero (YES in S106), the predicting unit 20c predicts that a possibility that the abnormal temperature immediately occurs is low but the abnormal temperature may occur in a long term and, thus, the rack has to be monitored. Accordingly, the predicting unit 20c outputs an alarm (S107). If the second derivative "d(dT/dt)/dt" of the temperature gradient is not larger than or equal to zero (NO in S106), the predicting unit 20c predicts that the possibility that the abnormal temperature immediately occurs is high and, thus, the rack is in danger, and outputs an alarm (S108).

Thereafter, the predicting unit 20c executes feedback-control for lowering the temperature of air taken in by the IT devices by controlling fans of the IT devices and sending the predicted result to the data processing apparatus 30 (S109). The temperature predicting apparatus 10 then repeats the processing from S102.

### [Effects of the first embodiment]

In accordance with the first embodiment, abnormal temperature of air for use in cooling of IT devices may be prevented or early detected. Since a temperature change tendency in the data center 1 may be chronologically predicted, unstable temperature behavior in the data center 1 may be early detected and, thus, the data center 1 may be operated and maintained in a stable temperature environment. Additionally, an alarm may be generated or feedback-control may be executed to improve the reliability and to decrease the power consumption of the data center 1.

More specifically, since the temperature predicting apparatus 10 according to the first embodiment may identify racks likely to suffer from abnormal temperature before the abnormal temperature actually occurs, the temperature predicting apparatus 10 may prevent or early detect the possible abnormal temperature. The temperature predicting apparatus 10 measures temperature of each rack and predicts whether the temperature of the rack will reach an unallowable level on the basis of the measured temperature instead of determining whether room temperature has reached an upper limit or a lower limit. Since the temperature predicting apparatus 10 may identify racks likely to suffer from the abnormal temperature and take measures for each of the racks, the temperature predicting apparatus 10 may prevent other IT devices from being cooled too much. Because the cooling operation and the heating operation are not frequently switched in the data center 1, an electric cost may be decreased.

When a rack suffers from recirculation of exhaust air and is predicted to have a temperature rise in intake air, the recirculation of exhaust air affects racks neighboring the suffering rack. Even in such a case, in accordance with the first embodiment, since the temperature of the intake air may be predicted for each rack, temperature abnormalities including a secondary problem caused by the abnormal state may also be predicted.

### [Second Embodiment]

Although the description has been given, not limitedly, for the case in which the temperature sensor is installed for each rack in the first embodiment, processing similar to that of the first embodiment may be executed when the temperature sensor is installed for each IT device stored in the racks, for example.

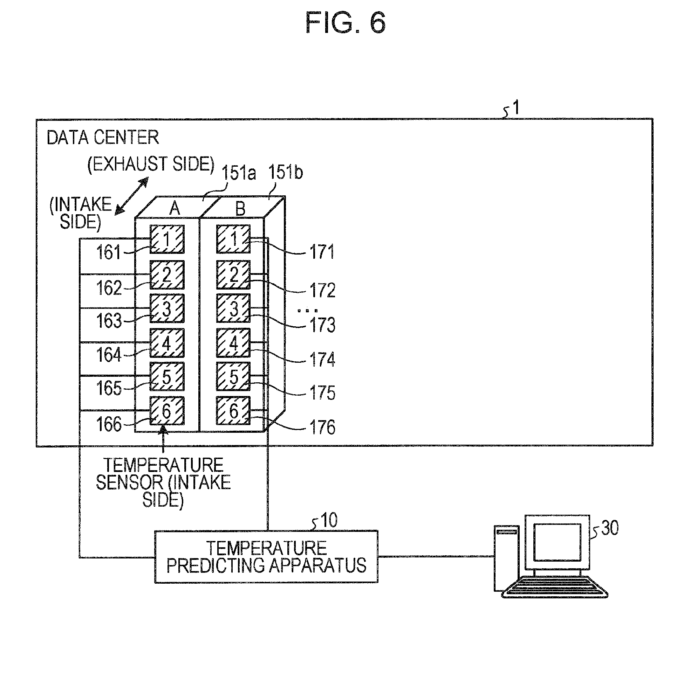

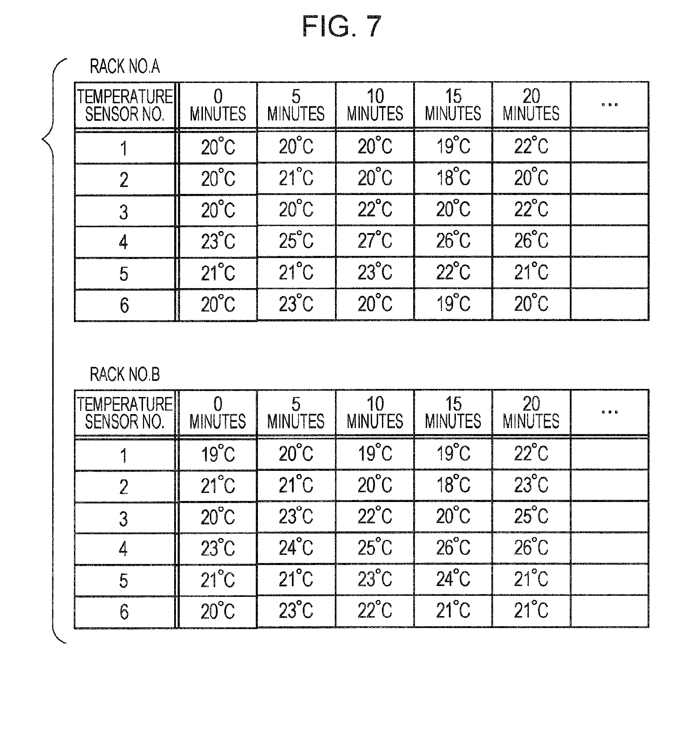

In a second embodiment, the description is given for an example in which a temperature sensor is installed for each IT device stored in racks using FIGs. 6 and 7. FIG. 6 is a diagram illustrating a configuration of a temperature predicting system including the temperature sensor installed for each IT device. FIG. 7 is a diagram illustrating an example of temperature information acquired from the temperature sensor installed for each IT device.

As illustrated in FIG. 6, a temperature predicting system according to the second embodiment includes, as in the case of the first embodiment, a data center 1, a temperature predicting apparatus 10, and a data processing apparatus 30. The second embodiment differs from the first embodiment in that a temperature sensor is installed on an intake side of each IT device stored in racks. In this example, six IT devices are stored in one rack and six temperature sensors are installed for the respective IT devices. However, the example limits neither the number of IT devices nor the number of temperature sensors.

The temperature predicting apparatus 10 is connected to temperature sensors 161-166 of a rack 151a and temperature sensors 171-176 of a rack 151b. The temperature predicting apparatus 10 acquires temperature from each of the temperature sensors 161-166 and 171-176. For example, as illustrated in FIG. 7, the temperature predicting apparatus 10 chronologically stores, for each "rack No." for identifying a rack, temperature information acquired from each of the temperature sensors included in the rack. FIG. 7 illustrates temperature information acquired, every five minutes, from the temperature sensors (Nos. 1-6) 161-166 installed in the rack (No. A) 151a and temperature information acquired, every five minutes, from the temperature sensors (Nos. 1-6) 171-176 installed in the rack (No. B) 151b.

The example in FIG. 7 indicates that temperature acquired from the temperature sensor (No. 1) 161 of the rack (No. A) 151a is 20°C at a point of measurement start (after 0 minutes), 20°C after 5 minutes, 20°C after 10 minutes, 19°C after 15 minutes, and 22°C after 20 minutes. The example also indicates that temperature acquired from the temperature sensor (No. 3) 173 of the rack (No. B) 151b is 20°C at the point of measurement start (after 0 minutes), 23°C after 5 minutes, 22°C after 10 minutes, 20°C after 15 minutes, and 25°C after 20 minutes.

In such an example, the temperature predicting apparatus 10 may estimate a temperature change tendency and predict possible abnormal temperature using a method similar to that of the first embodiment. More specifically, a temperature acquiring unit 20a acquires temperature of air taken in by the IT devices stored in the racks 151a and 151b from the temperature sensors 161-166 and 171-176 installed for the IT devices, respectively. The temperature acquiring unit 20a then stores the acquired temperature in a temperature history DB 15a.

After a predetermined time (e.g., after one hour) since the temperature acquiring unit 20a has started acquiring the temperature, an estimating unit 20b estimates, for each of the temperature sensors 161-166 and 171-176, a temperature change tendency of air taken in by the corresponding IT device using the temperature information acquired up to that point. That is, the estimating unit 20b estimates, for each IT device, a temperature change tendency of air taken in by the IT device.

Thereafter, a predicting unit 20c predicts possible abnormal temperature on the basis of the temperature change tendency estimated by the estimating unit 20b using a method similar to that of the first embodiment. That is, the predicting unit 20c predicts, for each IT device, possible abnormal temperature of air taken in by the IT device.

In this way, the temperature predicting apparatus 10 may predict possible abnormal temperature for each IT device and may prevent or early detect, for each IT device, a temperature abnormality. Additionally, since the temperature predicting apparatus 10 may chronologically predict the temperature change tendency within the data center 1 in detail, the data center 1 may be operated and maintained in a stable temperature environment.

### [Third Embodiment]

Although the predicting method using a temperature gradient has been described in the first and second embodiments, the predicting method is not limited to this one. For example, time for temperature to reach a dangerous level is predicted and an alarm is generated depending on whether the time is greater than or equal to a threshold.

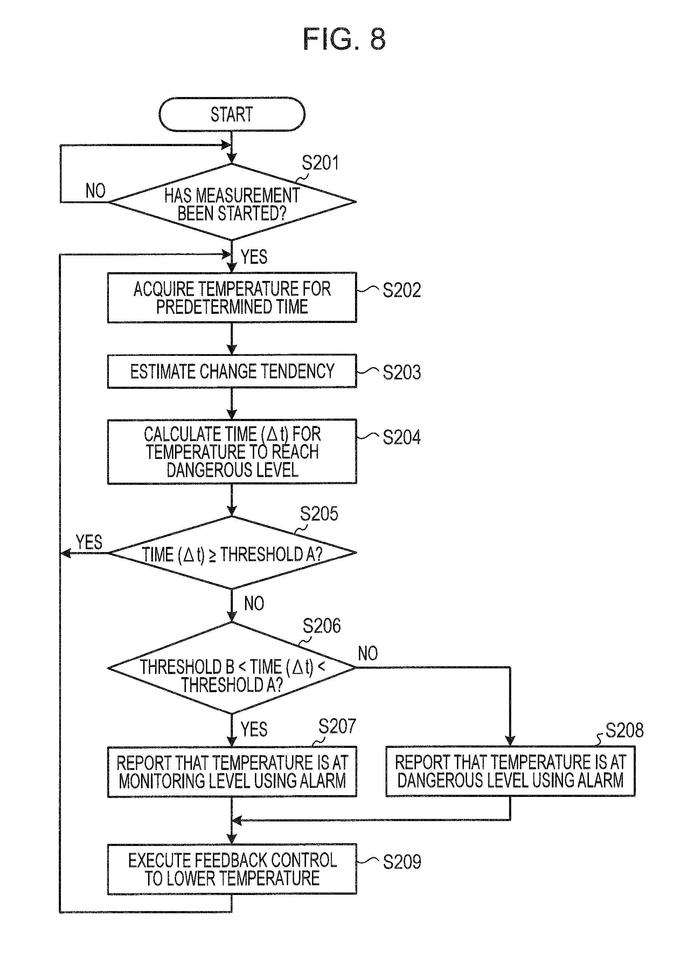

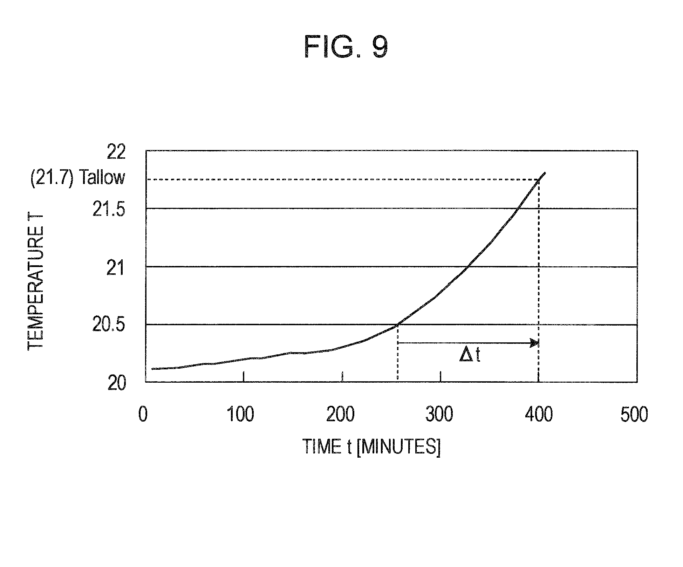

In a third embodiment, using FIGs. 8 and 9, the description will be given for an example in which time for temperature to reach a dangerous level is predicted and an alarm is outputted depending on whether the time is greater than or equal to a threshold. FIG. 8 is a flowchart describing a flow of processing executed by a temperature predicting apparatus 10 according to the third embodiment. FIG. 9 is a diagram describing a method for calculating time for temperature to reach a predetermined threshold on the basis of an estimated temperature change tendency.

As illustrated in FIG. 8, once an input section 12 accepts an instruction for starting temperature prediction, a temperature acquiring unit 20a starts measuring temperature (YES in S201). The temperature acquiring unit 20a then acquires temperature from each temperature sensor for a predetermined time and stores the acquired temperature in a temperature history DB 15a (S202). The temperature sensor may be installed for each rack just like the first embodiment or may be installed for each IT device just like the second embodiment.

An estimating unit 20b estimates a temperature change tendency of air taken in by the IT device stored in each rack using the temperature information acquired during the predetermined time (S203). For example, the estimating unit 20b creates a graph representing the estimated temperature change tendency.

After the estimation of the temperature change tendency, a predicting unit 20c calculates time (Δt) for the temperature to reach a predetermined level (e.g., 21.7 °C) on the basis of the temperature change tendency estimated by the estimating unit 20b (S204). For example, as illustrated in FIG. 9, the predicting unit 20c calculates the time (Δt) for the temperature to reach 21.7 °C on the basis of the temperature change graph estimated and created by the estimating unit 20b. A temperature rise from the start of measurement may be represented as a graph. In such a case, the time (Δt) for the temperature rise to reach a predetermined threshold (e.g., 21.7 °C) may be calculated.

The predicting unit 20c then determines whether the calculated time (Δt) is greater than or equal to a predetermined threshold A (e.g., 200 minutes) (S205). If the calculated time (Δt) is greater than or equal to the predetermined threshold A (YES in S205), the predicting unit 20c predicts a possibility that abnormal temperature occurs is low and the rack or the IT device is safe. The temperature predicting apparatus 10 then repeats the processing from S202.

If the calculated time (Δt) is less than the predetermined threshold A (NO in S205), the predicting unit 20c then determines whether the calculated time (Δt) is greater than another threshold B (e.g., 100 minutes) (S206).

If the calculated time (Δt) is greater than the threshold B (YES in S206), the predicting unit 20c predicts that a possibility that the abnormal temperature immediately occurs is low but the abnormal temperature may occur in a long term and, thus, the rack or the IT device has to be monitored. Accordingly, the predicting unit 20c outputs an alarm (S207). If the calculated time (Δt) is not greater than the threshold B (NO in S206), the predicting unit 20c predicts that the possibility that the abnormal temperature immediately occurs is high and the rack or the IT device is in danger, and outputs an alarm (S208).

Thereafter, the predicting unit 20c executes feedback-control for lowering the temperature of air taken in by the IT devices by controlling fans of the IT devices and sending the predicted result to the data processing apparatus 30 (S209). The temperature predicting apparatus 10 then repeats the processing from S202.

In this way, the temperature predicting apparatus 10 may predict, for each rack or for each IT device, the time for the temperature to reach the dangerous level and early detect possible abnormal temperature. Since measures taken in response to early detection of the possible abnormal temperature may prevent the abnormal temperature from actually occurring, the data center 1 may be operated and maintained in a stable temperature environment.

### [Fourth Embodiment]

Although the embodiments of the temperature predicting apparatus 10 disclosed by this application have been described, the temperature predicting apparatus 10 may be embodied in various different ways other than the foregoing embodiments. As a fourth embodiment, other embodiments included in this application will be described below.

### [Comparison with the temperature on the exhaust side]

For example, temperature sensors are installed on an exhaust side of IT devices. A temperature change on the exhaust side is estimated in a manner similar to the foregoing temperature estimation method for the intake side. If a difference between the temperature change on the intake side and the temperature change on the exhaust side is larger than or equal to a threshold, the estimated temperature-change value may be excluded from the prediction target. In this way, since a rack or an IT device that is possibly suffering from a failure may be excluded from the prediction target, the prediction accuracy may be improved and the prediction processing speed may be increased.

### [Linkage with other sensors]

Although the description has been given for the example using the temperature sensors in the foregoing embodiments, prediction processing similar to that of the foregoing embodiments may be executed when sensors other than the temperature sensors, such as airflow sensors and humidity sensors, are used.

### [System]

Each of the components of each of the illustrated apparatuses is only a functional concept and does not have to be physically configured in the illustrated manner. More specifically, a specific configuration for distributing or integrating the apparatuses is not limited to the illustration. The whole or part of the apparatuses may be functionally or physically distributed or integrated in a given unit depending of various load and usage states. For example, the estimating unit 20b and the predicting unit 20c may be integrated. The processing procedures, the control procedures, and the specific names mentioned in this specification and the accompanying drawings; and information including various kinds of data and parameters illustrated in, for example, FIGs. 3 and 7 may be changed unless otherwise noted.

### [Programs]

The various kinds of processing having been described in the foregoing embodiments may be realized by executing prepared programs in computer systems, such as a personal computer and a workstation. A description will be given below for an example of the computer systems for executing programs having functions similar to those of the foregoing embodiments.

### [Computer system for executing a temperature predicting program]

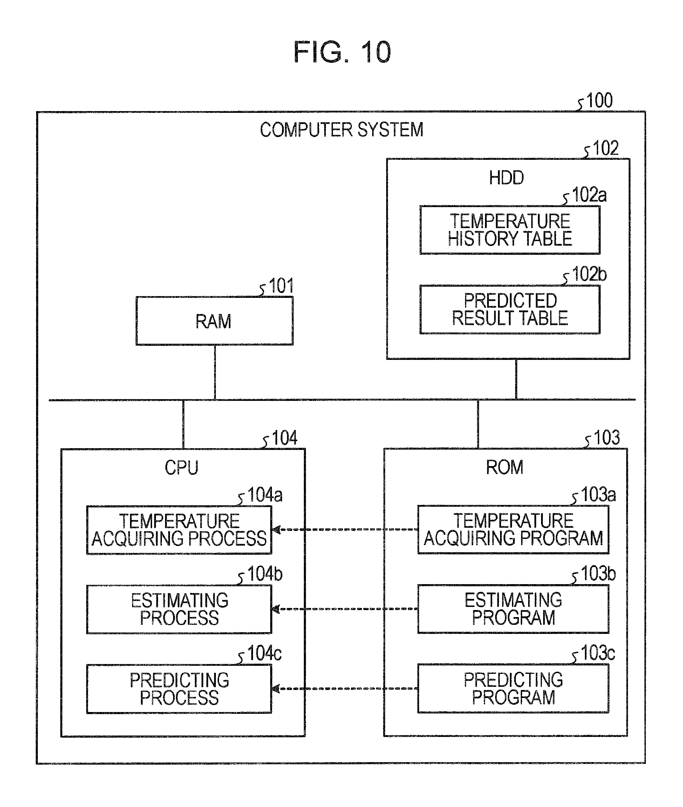

FIG. 10 is a diagram illustrating a computer system for executing a temperature predicting program. As illustrated in FIG. 10, a computer system 100 includes a RAM 101, an HDD 102, a ROM 103, and a CPU 104. The ROM 103 prestores programs demonstrating functions similar to those of the foregoing embodiments. More specifically, as illustrated in FIG. 10, the ROM 103 prestores a temperature acquiring program 103a, an estimating program 103b, and a predicting program 103c.

The CPU 104 reads out and executes the temperature acquiring program 103a, the estimating program 103b, and the predicting program 103c. More specifically, as illustrated in FIG. 10, the CPU 104 creates a temperature acquiring process 104a, an estimating process 104b, and a predicting process 104c. The temperature acquiring process 104a corresponds to the temperature acquiring unit 20a illustrated in FIG. 2. Similarly, the estimating process 104b and the predicting process 104c correspond to the estimating unit 20b and the predicting unit 20c, respectively.

The HDD 102 includes a temperature history table 102a for storing temperature information acquired by the temperature acquiring process 104a and a predicted result table 102b for storing predicted results. The temperature history table 102a corresponds to the temperature history DB 15a illustrated in FIG. 2. Similarly, the predicted result table 102b corresponds to the predicted result DB 15b.

The temperature acquiring program 103a, the estimating program 103b, and the predicting program 103c do not have to be prestored in the ROM 103. For example, the programs 103a, 103b, and 103c may be stored on, for example, "portable physical media" to be inserted into the computer system 100, such as a flexible disk (FD), a compact disc-read only memory (CD-ROM), a magneto-optical (MO) disk, a digital versatile disc (DVD), and an integrated circuit (IC) card. Additionally, the programs 103a, 103b, and 103c may be stored on "fixed physical media" provided inside or outside the computer system 100, such as HDDs. Furthermore, the programs 103a, 103b, and 103c may be stored in "other computer systems" connected to the computer system 100 via a public line, the Internet, a local area network (LAN), and a wide area network (WAN). The computer system 100 may read out the programs 103a, 103b, and 103c therefrom and execute the programs 103a, 103b, and 103c.

As described above, in accordance with one embodiment of the temperature predicting apparatus, the temperature predicting method, and the temperature predicting program disclosed by this application, possible abnormal temperature of air for use in cooling of IT devices may be advantageously prevented or early detected.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiments of the present invention have been described in detail, it should be understood that the various changes, substitutions, and alterations could be made hereto without departing from the spirit and scope of the invention.

## Claims

1. A temperature predicting apparatus for predicting possible abnormal temperature of air for cooling at least one of electronic devices mounted on a rack, the temperature predicting apparatus comprising:
a storing section for storing temperature information related to at least one temperature measured by a temperature sensor provided on an intake side of the electronic device; and
a controller for estimating a change tendency in the temperature on the intake side of the electronic device on the basis of the temperature information stored in the storing section, and predicting the possible abnormal temperature on the basis of the estimated change tendency.

2. The temperature predicting apparatus according to claim 1, wherein the temperature sensor measures the temperature at a predetermined interval and is provided for the rack or each of the electronic devices mounted on the rack.

3. The temperature predicting apparatus according to claim 1, wherein the controller calculates a temperature gradient on the basis of the estimated change tendency, and generates an alarm information to report the possible abnormal temperature on condition that the calculated temperature gradient exceeds a predetermined threshold.

4. The temperature predicting apparatus according to claim 2, wherein the controller calculates a temperature gradient on the basis of the estimated change tendency, and generates an alarm information to report the possible abnormal temperature on condition that the calculated temperature gradient exceeds a predetermined threshold.

5. The temperature predicting apparatus according to claim 1, wherein the controller estimates time for the temperature to reach a predetermined threshold on the basis of the estimated change tendency, and generates an alarm information to report the possible abnormal temperature on condition that the estimated time is less than or equal to a predetermined time threshold.

6. The temperature predicting apparatus according to claim 2, wherein the controller estimates time for the temperature to reach a predetermined threshold on the basis of the estimated change tendency, and generates an alarm information to report the possible abnormal temperature on condition that the estimated time is less than or equal to a predetermined time threshold.

7. A temperature predicting method for predicting possible abnormal temperature of air for cooling at least one of electronic devices mounted on a rack, the temperature predicting method comprising:
acquiring, by a controller, temperature information related to at least one temperature measured by a temperature sensor provided on an intake side of the electronic device;
estimating a change tendency in the temperature on the intake side of the electronic device by the controller on the basis of the temperature information; and
predicting the possible abnormal temperature by the controller on the basis of the estimated change tendency.

8. The temperature predicting method according to claim 7, further comprising:
calculating a temperature gradient by the controller on the basis of the estimated change tendency; and
generating an alarm information to report the possible abnormal temperature by the controller on condition that the calculated temperature gradient exceeds a predetermined threshold.

9. The temperature predicting method according to claim 7, further comprising:
estimating time for the temperature to reach a predetermined threshold by the controller on the basis of the estimated change tendency; and
generating an alarm information to report the possible abnormal temperature by the controller on condition that the estimated time is less than or equal to a predetermined time threshold.

10. A storage medium storing a temperature predicting program for predicting possible abnormal temperature of air for cooling at least one of electronic devices mounted on a rack, the temperature predicting program allowing a controller of a computer to execute an operation, the operation comprising:
acquiring ,by a controller, temperature information related to at least one temperature measured by a temperature sensor provided on an intake side of the electronic device;
estimating a change tendency in the temperature on the intake side of the electronic device by the controller on the basis of the temperature information; and
predicting the possible abnormal temperature by the controller on the basis of the estimated change tendency.

11. The storage medium according to claim 10, further comprising:
calculating a temperature gradient by the controller on the basis of the estimated change tendency; and
generating an alarm information to report the possible abnormal temperature by the controller on condition that the calculated temperature gradient exceeds a predetermined threshold.

12. The storage medium according to claim 10, further comprising:
estimating time for the temperature to reach a predetermined threshold by the controller on the basis of the estimated change tendency; and
generating an alarm information to report the possible abnormal temperature by the controller on condition that the estimated time is less than or equal to a predetermined time threshold.
